# EUROPEAN PATENT SPECIFICATION

(11) **EP 0 433 002 B1**
(45) Date of publication and mention of the grant of the patent: **04.09.1996**
(21) Application number: 90313412.0
(22) Date of filing: 11.12.1990
(51) Int. Cl.: G01R 33/38, G01R 33/42

(54) **Magnetic resonance imaging system including active shield gradient coils**
System zur Bilderzeugung mittels magnetischer Resonanz mit aktiv abgeschirmten Gradientenspulen
Système d'imagerie à résonance magnétique comprenant des bobines de gradient à blindage actif

(30) Priority: 11.12.1989 JP 318942/89
(43) Date of publication of application: 19.06.1991
(73) Proprietor: KABUSHIKI KAISHA TOSHIBA, Kawasaki-shi, Kanagawa-ken 210 (JP)
(72) Inventor: Sugimoto, Hiroshi, Nasu-gun, Tochigi-ken (JP)
(74) Representative: BATCHELLOR, KIRK & CO.

(56) References cited:
- EP-A- 0 293 723
- EP-A- 0 317 853
- GB-A- 2 229 820
- JOURNAL OF PHYSICS E. SCIENTIFIC INSTRUMENTS. vol. 19, 1986, ISHING, BRISTOL GB pages 540 - 545; P. MANSFIELD, B. CHAPMAN: "Active magnetic screening of coils for static and time-dependent magnetic field generation in NMR imaging"
- JOURNAL OF MAGNETIC RESONANCE. vol. 80, no. 2, November 1988, ORLANDO, MN US pages 248 - 258; R. TURNER ET AL.: 'Snap-Shot Magnetic Resonance Imaging at 0. 1T Using Double-Screened Gradients '
- JOURNAL OF PHYSICS D. APPLIED PHYSICS. vol. 19, 1986, LETCHWORTH GB pages 129 - 131; B. CHAPMAN, P. MANSFIELD: 'Double active magnetic screening of coils in NMR '

## Description

The present invention relates to a magnetic resonance imaging system employing active shield gradient coils for magnetically cancelling a leakage gradient field. More specifically, the present invention is directed to an active shield gradient coil system for reducing eddy current loss occurring in heat-shield members for maintaining the superconducting coil assembly at very low temperatures.

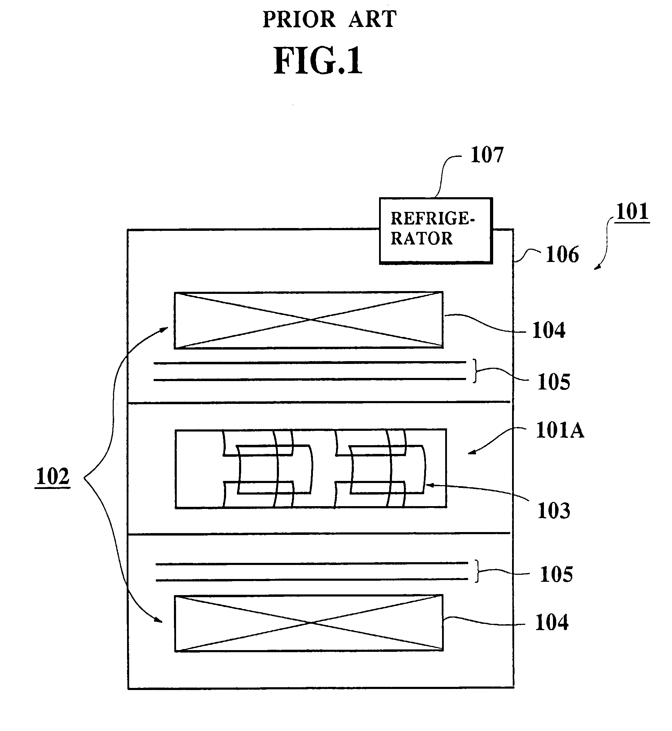

Figure 1 shows as conventional magnetic resonance (hereinafter referred to as "MR") imaging apparatuses. This conventional MR imaging apparatus comprises a gantry 101 having an imaging chamber in a bore 101A. In this gantry 101, there are provided a superconducting magnet 102 around the outer portion thereof for producing a uniform static magnetic field and a gradient field coil 103 for producing a gradient magnetic field to be superimposed with the static magnetic field within the magnet bore 101A. The superconducting magnet 102 is so constructed that both a toroidal superconducting coil 104 immersed in a liquid helium bath (not shown in detail), and a heat shield tube 105 for thermally shielding the superconducting coil 104 are contained in an outer vessel 106, the cross-sectional shape of which is toroidal. A refrigerator 107 is employed so as to cool the superconducting magnet 5 using helium gas.

During an MR imaging operation, an object under medical examination, e.g. a patient (not shown) is inserted into the magnet bore 101A, the static magnetic field produced from the superconducting magnet 102 is uniformly applied particularly to a specific portion (a portion to be imaged) of the patient, and also RF magnetic fields are applied thereto in a direction perpendicular to the application direction of the static magnetic field. Furthermore, since the preselected gradient magnetic fields produced from the above-described gradient field coil 103 are superimposed on the static magnetic field, the MR phenomenon may occur only at the specific slice portion of the object under medical examination and an MR signal (e.g. FID signal and spin echo signal) generated from the specific slice portion is acquired after the application of the RF fields has been accomplished. The acquired MR signal is further processed in the image data processor (not shown) by way of e.g.,Fourier transform, whereby tomographic images may be reconstructed and desirable tomographic images may be displayed on a monitor (not shown).

When the gradient magnetic fields are produced from the gradient magnetic coil 103, pulsatory leakage fields may occur so that eddy currents will be produced on the heat shield tube 105 for maintaining the superconducting magnet 104 at a very low temperature, and furthermore, another pulsatory magnetic field is newly generated by these eddy currents, which will in turn be superimposed with the existing gradient fields. As a result, the resultant gradient magnetic fields cannot provide the required gradient magnetic field, i.e. the required magnetic flux levels and distribution patterns. Accordingly, artifacts may be induced in the tomographic images and the signal level of the MR signal is lowered, resulting in deterioration of image quality.

EP 29 37 23 discloses a magnetic coil system comprising superconductive coils (11, 13) providing a homogenous background magnetic field and normally conductive coils (8) providing a magnetic field gradient. A cooled radiation shield (18) of an electrically and thermally conductive material is inserted between the gradient coils (8) and the super conductive coils (11..13).

The radiation shield (18) comprises superconductive material of a high-temperature superconductor for passive shielding of the magnetic field gradient.

To solve the above-described problems caused by the leakage field from the gradient field, a so-called "active shield method" has been proposed.

For instance, see U.S. Patent No. 4,737,716 issued to Roemer et al on April 12, 1988; U.S. Patent No. 4,733,189 issued to Punchard et al. on March 22, 1988; and U.S. Patent No. 4,794,338 on December 27, 1988.

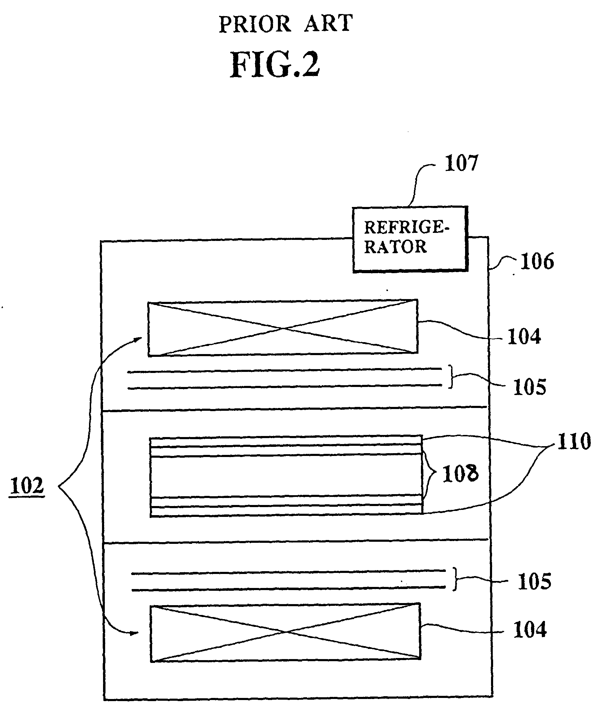

A basic idea of such a conventional active shield method will now be summarised with reference to an illustration of Figure 2. It should be noted that the same reference numerals employed in Figure 1 are employed to denote the same or similar components shown in Figure 2.

As shown in Figure 2, an active shield gradient coil 110 is employed between the gradient coil 108 and superconducting magnet 102 in order to cancel the above-described leakage field by superimposing a gradient shield field 110 onto the leakage field. The field direction of this gradient shield field is opposite to that of the leakage field. Accordingly, employment of the active shield gradient coil 110 can prevent eddy currents from being produced in the heat shield tube 105. In general, both the gradient field coil 108 and active shield gradient coil 110 are mounted within a bore (whose typical diameter is approximately 1,000mm) of the outer vessel 106.

However, this type of "active shield" causes another problem, that is, since the gradient field coil 108 is positioned in close proximity to the active shield gradient coil 110, a large energising current must be supplied to the active shield gradient coil 110 so as to sufficiently cancel the gradient leakage field leaked from the gradient magnetic field of the active shield gradient coil 110. Therefore, the total power consumption is increased and considerable heat dissipation will occur from the active shield gradient coil 110.

In addition, to reduce the heat output from the active shield gradient coil 110, another cooling means different from the above-described refrigerator 107 is additionally required.

As previously described, since two coil energising currents having mutually opposite flow directions must be supplied to the coils 108 and 110, and thus the difference between the field strengths of these coils 108 and 110 becomes the resultant gradient field actually supplied to the patient (not shown), the following problem may occur. That is, the smaller the spacing between the two coils 108 and 110, the smaller the difference between the field strengths produced by these coils become, so that the strength of the actually applied gradient field becomes small in inverse proportion to currents flowing in the coils 108 and 110 and the desired gradient field cannot be effectively produced.

To separate these coils 108 and 110 from each other as long as possible within the bore, the diameter of the bore must be enlarged. However, this causes the drawback that the entire dimension of the superconducting magnet 102 becomes large, and therefore a large installation space and higher costs are necessarily required. In a particular case, the existing examination room for the MR imaging purpose cannot be used and a new examination room with a higher ceiling height must be prepared for installing such large-sized MR imaging apparatus. Alternatively, the diameter of the gradient magnetic coil 108 may be reduced. However, this causes the further difficulty that the patient must be inserted into a narrower space, which then in turn induce claustrophobia.

Accordingly, the above-described solutions have not yet been realised in the practical MR imaging field.

Furthermore, if the above-described active shield gradient coil were to be installed in the bore of an existing conventional MR imaging apparatus shown in Figure 1, the present diameter of this bore would have to be increased and therefore huge modification costs and difficulties would be incurred.

In accordance with another practical solution, slots may be formed in the heat shield tube 105 so as to suppress the eddy current loss. However, the leakage field generated by the gradient field coil 108 may reach the above-described liquid helium container inside the heat shield tube 105 and thus cause further eddy current losses in this liquid helium container. As a consequence, the total amount of liquid helium which is evaporated is increased due to this eddy current heat dissipation.

The present invention has been made in an attempt to solve the above-described drawbacks of the conventional MR imaging systems, and therefore seeks to provide an MR imaging system including an active shield gradient coil capable of being energised with lower power consumption and also capable of effectively reducing eddy current effects.

The present invention also seeks to provide an MR imaging system capable of reducing total heat dissipation of heat shield members for a superconducting coil system and capable of improving the quality of tomographic images.

A magnetic resonance imaging apparatus, according to the present invention, comprises:
a magnetic resonance imaging unit (600) having an imaging chamber (3) to receive a subject (P) under medical examination;
a superconducting coil unit contained within an outer vessel which surrounds the imaging chamber,and including superconducting coil means for uniformly producing a static magnetic field to be applied to the subject, and at least one heat shield member for thermally shielding the superconducting coil means;
gradient field coil means provided between the outer vessel and imaging chamber, for producing a gradient magnetic field so as to be superimposed on the static magnetic field, characterised by:
active shield gradient coil means for producing a gradient shield, and disposed within the outer vessel in such a manner that the active shield gradient coil means is thermally coupled to the heat shield member and magnetically coupled with a leakage field from the gradient magnetic field of the gradient field coil means, whereby the leakage field is magnetically cancelled by the gradient shield field and substantially no eddy current is produced in the heat shield member.

Some embodiments of the present invention will now be described by way of example with reference to the accompanying drawings, in which:
Figures 1 and 2 are illustrations of two typical conventional MR imaging systems;
Figure 3 is a diagrammatic illustration of the principles present invention;
Figure 4 schematically represents a scanner unit 500 employed in an MR imaging apparatus 1000 according to a first preferred embodiment of the present invention;
Figure 5 schematically represents a gantry unit 600 employed in the first MR imaging apparatus 1000;
Figure 6 schematically illustrates an overall system of the first MR imaging apparatus 1000; and,
Figure 7 pictorially illustrates an arrangement of the active shield gradient coil assembly employed in another MR imaging apparatus according to a second preferred embodiment.

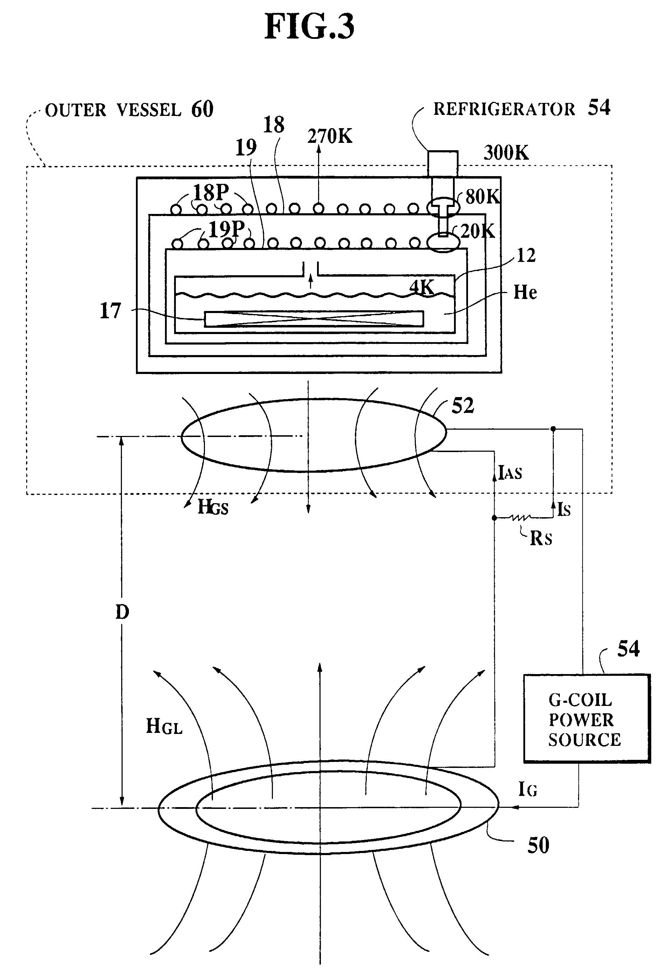

Figure 3 illustrates the general principles of the invention.

Pipes "18P" and "19P" for circulating liquid helium are fixed onto heat shield tubes 18 and 19 respectively for maintaining the superconducting coil 17 at very low temperatures. These heat shield tubes 18, 19 and pipes 18P, 19P are mechanically coupled to the refrigerator 54 in such a manner that the temperature of the outer heat shield tube 18 is maintained at approximately 80K, whereas the inner heat shield tube 19 is maintained at approximately 20K.

A gradient field coil assembly 50, an active shield gradient coil assembly 52, and a coil energising power supply 54, are employed in an MR imaging system according to the present invention.

The gradient coil assembly 50 is connected in series with the active shield gradient coil assembly 52 via the common gradient coil power source 54. Further, a shunt resistor "R_{S}" is connected across the active shield gradient coil assembly 52 so as to shunt the coil energising current "I_{G}", if required. Thus, a current "I_{AS}" flows through the active shield gradient coil assembly 52, whereas another current "I_{S}" flows through the shunt resistor "R_{S}".

In accordance with a major feature of the present invention, the active shield gradient coil assembly 52 is physically positioned apart from the gradient field coil assembly 50 by a distance "D" and housed within the outer vessel 60 so as to maintain the superconducting coil 15 at a very low temperature. That is, this spacing "D" between the active shield gradient coil assembly 52 and the gradient field coil assembly 50 is selected to be considerably larger than that of the convention MR imaging system shown in Figure 2. Accordingly, this active shield gradient coil assembly 52 is positioned in close proximity to the heat shield tubes 18 and 19 used for thermally shielding the superconducting coil 15 within the outer vessel 60.

Since the active shield gradient coil assembly 52 is physically spaced apart from the gradient field coil assembly 50, the following specific advantages may be achieved.

First, since only a part of the gradient leakage field "H_{GL}" produced from the gradient field coil assembly 50 reaches the active shield gradient coil assembly 52, the field strength of this gradient leakage field portion becomes quite small. As a result, the magnetic field strength of the active shield field "H_{GS}" used for magnetically cancelling this small field strength of the gradient leakage field "H_{GL}", can also be small.

Moreover, even if a part of the gradient leakage field "H_{GL}" cannot be magnetically cancelled by this active shield "H_{GS}" and reaches the heat shield tubes 18 and 19 and thus causes eddy current heat dissipation therein, only a very small temperature increase will be produced in these heat shield tubes 18 and 19. This may suppress the evaporation of liquid helium stored in a liquid helium tank 12, as compared with the above-described conventional MR imaging apparatus shown in Figure 2.

Consequently, as will be apparent from Figure 3, the required energising current "I_{AS}" for the active field coil assembly 52 to sufficiently and magnetically cancel the gradient leakage field "H_{GL}" intersecting this active shield gradient coil assembly 52, is quite small as compared within the conventional MR imaging apparatus shown in Figure 2. As a consequence, since the gradient leakage field "H_{GL}" actually intersecting this active shield gradient coil assembly 52 may be sufficiently cancelled, an eddy current loss caused by the uncancelled gradient leakage field becomes very small, as compared with the conventional MR imaging apparatus.

The relationship between the coil energising currents is as follows:${\text{I}}_{\text{G}} {\text{= I}}_{\text{AS}} {\text{+ I}}_{\text{S}} \text{,}$ where${\text{I}}_{\text{AS}} {\text{<< I}}_{\text{S}}$

In summary, an active shield gradient coil assembly of the type disclosed in, for instance, U.S. Patent No. 4,733,189, is spaced far apart from the gradient field coil assembly and positioned in close proximity to the heat shield tubes for maintaining the superconducting coil at very low temperatures.

Preferably, the active shield gradient coil assembly 52 may be positioned in close approximately to one heat shield tube 18 (generally, maintained at 80K) and may be cooled by the existing refrigerator 54 for also cooling the superconducting coil 17.

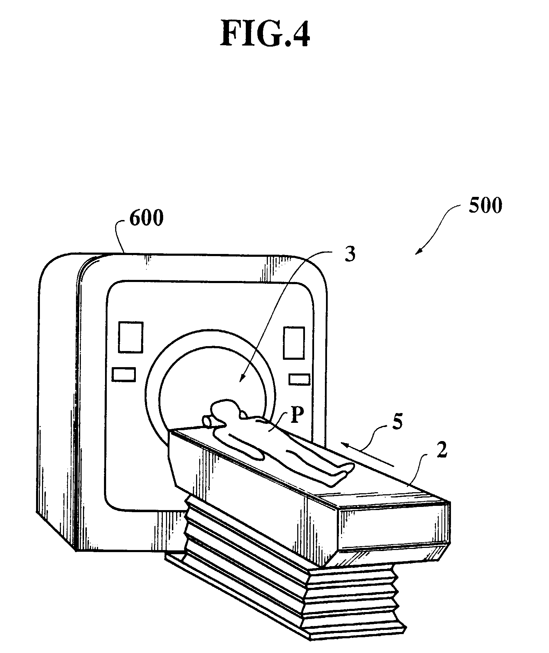

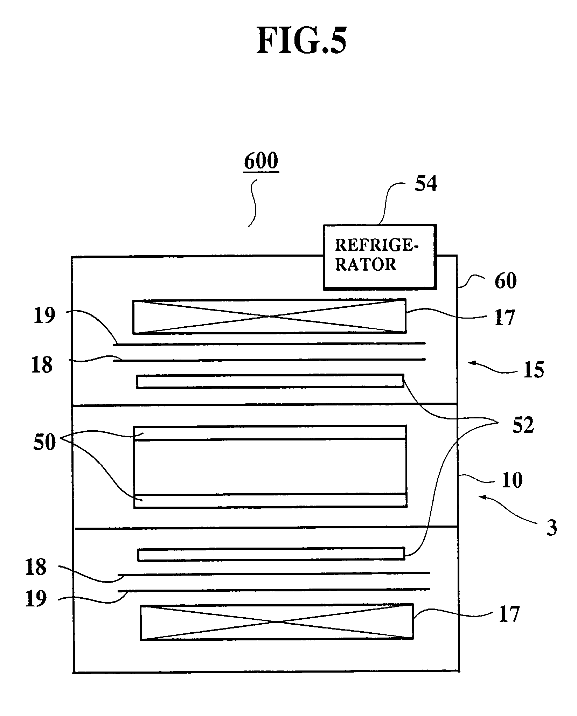

Referring now to Figures 4 and 5, a more complete construction of an MR imaging apparatus 1000 according to a first preferred embodiment of the present invention will be described.

Figure 4 schematically illustrates a scanner unit 500 employed in the MR imaging apparatus 1000, and Figure 5 schematically illustrates an arrangement of a gantry unit 600 employed therein.

As represent in Figure 4, a scanner unit 500 of the MR (magnetic resonance) imaging apparatus according to a preferred embodiment of the present invention, comprises a couch 2 for supporting a patient "P" and a gantry 4 having an imaging chamber 3. During the MR imaging operation, the couch 2 is moved in the direction of arrow 5, so as to introduce the patient into the imaging chamber.

As shown in Figure 5, there are provided around a peripheral portion within the gantry 4, a superconducting magnet 15 for uniformly producing a static magnetic field in the imaging chamber, and also a gradient field coil 50 for producing a gradient magnetic field to be superimposed with this static magnetic field. The superconducting magnet 15 is so constructed that a superconducting coil 17 is installed in the liquid helium tank 12 (see Figure 3) maintained at a very low temperature of about 4K, a second heat shield tube 19K for thermally shielding this superconducting coil 17, which is maintained at a low temperature of about 20K, and a first heat shield tube 18 outside the second heat shield tube 19, for thermally shielding the superconducting coil 17 via the second heat shield tube 19, which is maintained at a low temperature of about 50 to 80 K. These superconducting coil 17, first and second heat shield tubes 18 and 19 are contained within an outer vessel 60, whose sectional view is substantially toroidal. This toroidal outer vessel 60 is made of reinforced plastics such as FRP (Fiber Reinforced Plastics). The interior of the outer vessel 60 is evacuated and kept at a low pressure in order to shield externally transferred heat.

As the major feature of the present invention, an active shield gradient coil assembly 52 is contained within the outer vessel 60 and is positioned in close proximity to the first heat shield tube 18 and interposed between the imaging chamber and the first heat shield tube 18 within the outer vessel 60. As previously explained, the function of this active shield gradient coil assembly 52 is to magnetically cancel the gradient leakage field produced from the gradient field coil assembly 50 by supplying an energising current through the active shield gradient coil assembly 52, which is opposite the direction to the energising current flowing through the gradient field coil assembly 52. As a result, since the gradient leakage field may be substantially and magnetically cancelled by the gradient active shield field of this active shield gradient coil assembly 52 before this leakage field reaches the first and second heat shield tubes 18 and 19, substantially no eddy current flows through the first and second heat shield tubes 18 and 19.

It should be noted that the active shield gradient coil 52 is electrically insulated from the first and second heat shield tubes 18 and 19, and thermally connected thereto.

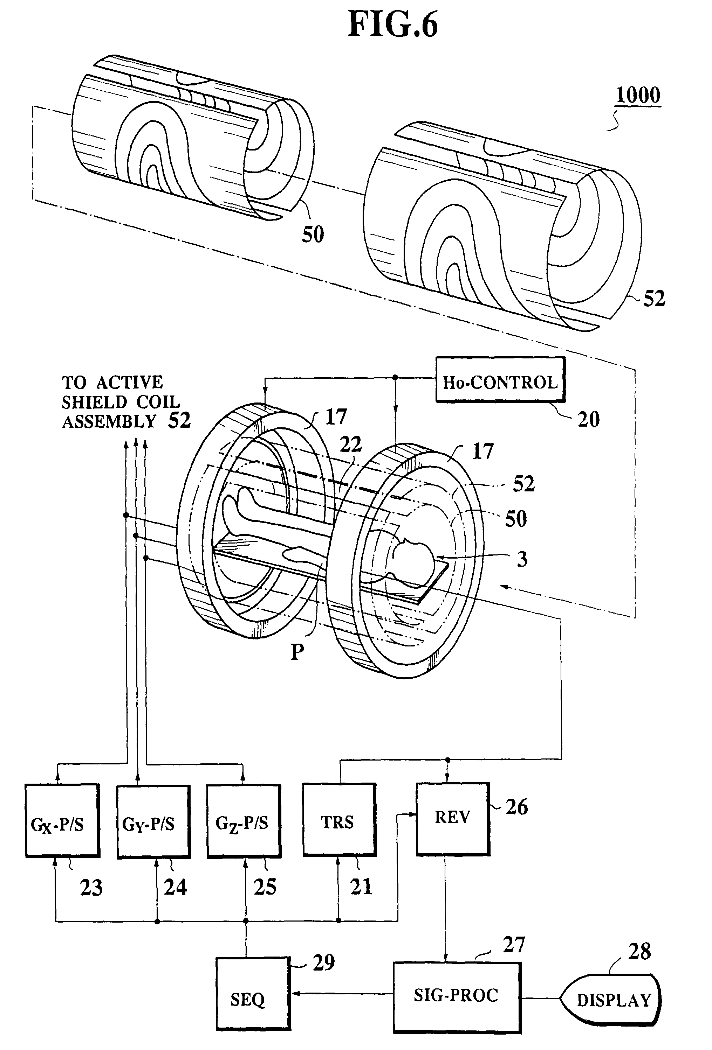

Figure 6 schematically shows the overall arrangement of the system of the first MR imaging apparatus 1000, from which the relationship between the gradient field coil assembly 50 and active shield gradient coil assembly 52 may be pictorially understood. For the sake of simplicity, the heat shield tubes 18, 19 and refrigerator 54 are omitted from Figure 6.

An overall imaging operation of the first MR imaging apparatus 1000 will now be described.

In the first MR imaging system 1000 Shown in Figure 6, the static magnetic field "H_{O}" is uniformly applied from the superconducting coil 17 to the subject "P" under medical examination inserted into the imaging chamber 3 mounted on the couch 2 in response to a control signal supplied from a static magnetic field controller 20. Further, in response to an RF (radio frequency) current furnished from a transmitter 21, an RF excitation field is applied from an RF coil and also each of the gradient magnetic fields generated from the gradient field coil assembly 52 is superimposed with the static magnetic field. This gradient field coil assembly 50 is energised by each of gradient field power sources 23, 24 and 25 for X-axis, Y-axis and Z-axis. At the same time, the above-described gradient active shield field is generated from the active shield gradient coil assembly 52 so as to magnetically cancel the gradient leakage field leaked from the gradient magnetic field.

Under the above-described conditions, an MR signal is produced from a specified portion of the subject "P" and received by the RF coil 22. Thereafter, this MR signal is supplied via a receiver 26 to a signal processor 27. In this signal processor 27, the MR signal is image-processed for example by a Fourier transform process so as to reconstruct tomographic images of the subject "P". Thus, tomographic image data representative of the reconstructed tomographic images are supplied to a display unit 28, whereby the tomograghic images of preselected slices of the subject "P" under medical examination may be monitored on the display unit 28. A sequencer 29 is employed to sequentially drive the respective gradient field power sources 23, 24 25, transmitter 21 and receiver 22.

As previously described, in accordance with the first MR imaging apparatus 1000, the active shield gradient coil assembly 52 is positioned close to the first heat shield tube 18 within the outer vessel 60 (see Figure 5), so that the space "D" (see Figure 3) between the gradient field coil assembly 50 and active shield gradient coil assembly 52 is considerably greater than that of the conventional MR imaging apparatus shown in Figure 2. As a consequence, since the field strength of the leakage field reaching the active shield gradient coil assembly 52 is relatively small, as compared with that of the conventional MR imaging apparatus, this leakage field may be sufficiently cancelled by the relatively small field strength of the active shield field before this leakage field reaches the first and second heat shield tubes 18 and 19. In other words, magnetic cancelling loss occurs when the desirable gradient field is produced becomes small.

As a result, the eddy current occurring in the first and second heat shield tubes 18 and 19 may be sufficiently suppressed even if only a small coil energising current flows through the active shield gradient coil assembly 52. Accordingly, the power capacity of an active shield gradient coil power supply (i.e. the gradient field power sources 23, 24 and 25) may be reduced, as compared with that of a conventional MR imaging apparatus.

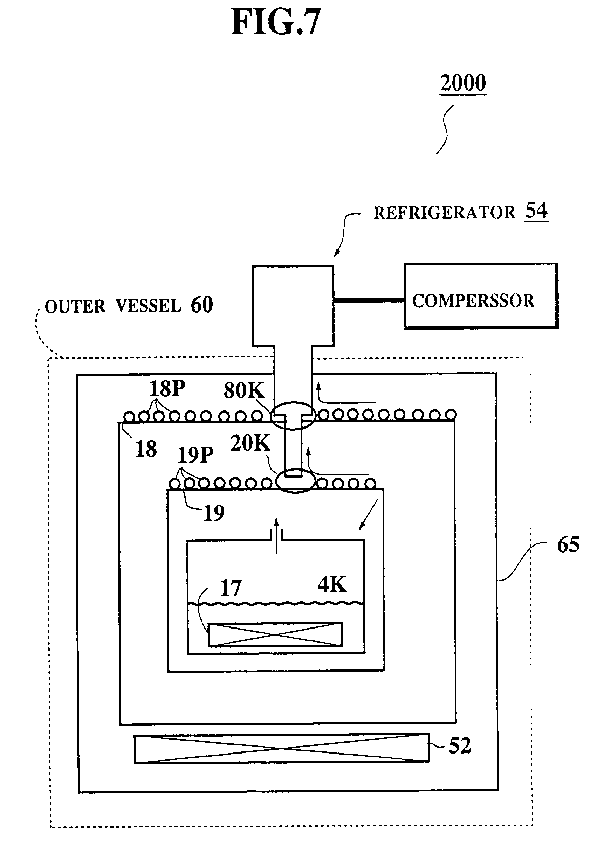

Figure 7 schematically illustrates a major part of an MR imaging apparatus 2000 according to a second preferred embodiment of the present invention.

As apparent from Figure 7, a major feature of the second MR imaging apparatus 2000 is that the active shield gradient coil assembly 52 is contained within a third heat shield tube 65 in the outer vessel 60, and is cooled by the refrigerator 54 which is also used to cool the superconducting magnet 57.

Since no separate refrigerator is required for cooling the coil assembly 52, the entire construction of the second MR imaging apparatus 2000 may be made simple and the manufacturing cost may be reduced.

The present invention also has various other advantages

For instance, since the relative position between the gradient field coil 50 and active shield gradient coil 52 may be varied in the first and second MR imaging apparatuses 1000 and 2000, assembly precision may be readily adjusted. In a conventional MR imaging apparatus having the bore with a small diameter without any active shield gradient coil assembly, when the active shield gradient coil assembly is employed within the outer vessel 106 for the superconducting magnet 104, this conventional MR imaging apparatus may be simply modified as an MR imaging apparatus of the present invention without changing the bore diameter.

Furthermore, the number of heat shield tubes for a refrigerator may be increased to more than 2, so as to provide better insulation, so that a more stable static magnetic field may be produced and thus the S/N ratio of the tomographic image may be further increased.

While the present invention has been described in detail, since the active shield gradient coil assembly is provided within the outer vessel of the superconducting magnet, and therefore the interval between the gradient field coil assembly and active shield gradient coil assembly becomes large, the field strength of the leakage field actually reaching the active shield gradient coil assembly is weakened and only the small current for energising the active shield gradient coil assembly can sufficiently cancel this leakage field.

Since the refrigerator for cooling the superconducting magnet may be used also to cool the active shield gradient coil assembly, no additional refrigerator is required.

## Claims

1. A magnetic resonance imaging apparatus (1000;2000) comprising:
a magnetic resonance imaging unit (600) having an imaging chamber (3) thereof, to receive a subject (P) under medical examination;
a superconducting coil unit (15) contained within an outer vessel (60) which surrounds the imaging chamber (3), and including superconducting coil means (17) for uniformly producing a static magnetic field to be applied to the subject (P), and at least one heat shield member (18) for thermally shielding the superconducting coil means (17);
gradient field coil means (50) provided between the outer vessel (60) and imaging chamber (3), for producing a gradient magnetic field so as to be superimposed on the static magnetic field, characterised by:
active shield gradient coil means (52) for producing a gradient shield (H_{GS}), and disposed within the outer vessel (60) in such a manner that the active shield gradient coil means (52) is thermally coupled to the heat shield member (18) and magnetically coupled with a leakage field (H_{GL}) from the gradient magnetic field of the gradient field coil means (50), whereby the leakage field (H_{GL}) is magnetically cancelled by the gradient shield field (H_{GS}) and substantially no eddy current is produced in the heat shield member (18).

2. A magnetic resonance imaging apparatus (1000;2000) as claimed in claim 1, wherein said active shield gradient coil means (52) is positioned in close proximity to the heat shield member (18) within the outer vessel (60).

3. A magnetic resonance imaging apparatus (1000;2000) according to claim 1 or claim 2 further comprising:
a second heat shield member (19) inside the heat shield member (18), for thermally enclosing said superconducting coil means (17).

4. A magnetic resonance imaging apparatus (1000) according to claim 3 further comprising:
a refrigeration unit (54) for cooling both of said heat shield members (18;19) to predetermined lower temperatures than the ambient temperature of the outer vessel (60).

5. A magnetic resonance imaging apparatus (2000) according to claim 3 further comprising:
a third heat shield member (65) for enclosing both of said second heat shield member (19) and said active shield gradient coil means (52) within the outer vessel (60); and,
a refrigerator (54) for cooling at least both of said first heat shield member (18) and said active shield gradient coil means (52) to preselected lower temperatures than an ambient temperature of the outer vessel (60).

6. A magnetic resonance imaging apparatus (1000;2000) as claimed in claim 1, wherein said heat shield member (18) is a tube.

## Patentansprüche

1. Magnetische Resonanz-Bildaufnahmevorrichtung (1000; 2000) mit:
einer magnetischen Resonanz-Bildaufnahmeeinheit (600), die eine Bildaufnahmekammer (3) hat, in der eine Person (P) zur medizinischen Untersuchung aufgenommen wird;
einer supraleitenden Spuleneinheit (15), die in einem äußeren Behälter (60), der die Bildaufnahmekammer (3) umgibt, enthalten ist und die supraleitende Spulenmittel (17) zur gleichmäßigen Erzeugung eines statischen Magnetfeldes, das auf die Person (P) einwirkt, und mindestens ein Hitzeschildelement (18) zur thermischen Abschirmung der supraleitenden Spulenmittel (17) hat;
Gradientenfeld-Spulenmitteln (50) zwischen dem äußeren Behälter (60) und der Bildaufnahmekammer (3) zur Erzeugung eines Gradientenmagnetfeldes, so daß es dem statischen Magnetfeld überlagert ist, **gekennzeichnet durch**:
aktive Abschirm-Gradientenspulenmittel (52) zur Erzeugung einer Gradientenabschirmung (H_{GS}), die innerhalb des äußeren Behälters (60) derart angeordnet sind, daß die aktiven Abschirm-Gradientenspulenmittel (52) thermisch mit dem Hitzeschildelement (18) und magnetisch mit einem Leckfeld (H_{GL}) des Gradientenmagnetfeldes der Gradientenfeld-Spulenmittel (50) gekoppelt sind, wobei das Leckfeld (H_{GL}) magnetisch durch das Feld der Gradientenabschirmung (H_{GS}) aufgehoben wird und im wesentlichen keine Wirbelströme in dem Hitzeschildelement (18) erzeugt werden.

2. Magnetische Resonanz-Bildaufnahmevorrichtung (1000; 2000) nach Anspruch 1, wobei die aktiven Abschirm-Gradientenspulenmittel (52) in geringem Abstand zu dem Hitzeschildelement (18) in dem äußeren Behälter (60) angeordnet sind.

3. Magnetische Resonanz-Bildaufnahmevorrichtung (1000; 2000) nach Anspruch 1 oder 2, weiterhin mit:
einem zweiten Hitzeschildelement (19) innerhalb des Hitzeschildelements (18) zum thermischen Einschließen der supraleitenden Spulenmittel (17).

4. Magnetische Resonanz-Bildaufnahmevorrichtung (1000) nach Anspruch 3, weiterhin mit:
einer Kühleinheit (54) zur Kühlung beider Hitzeschildelemente (18; 19) auf festgelegte niedrigere Temperaturen als die Umgebungstemperatur des äußeren Behälters (60).

5. Magnetische Resonanz-Bildaufnahmevorrichtung (2000) nach Anspruch 3, weiterhin mit:
einem dritten Hitzeschildelement (65) zum Einschließen sowohl des zweiten Hitzeschildelements (19) als auch der aktiven Abschirm-Gradientenspulenmittel (52) innerhalb des äußeren Behälters (60); und mit
einer Kühleinheit (54) zur Kühlung von mindestens sowohl dem ersten Hitzeschildelement (18) als auch der aktiven Abschirm-Gradientenspulenmittel (52) auf festgelegte niedrigere Temperaturen als die Umgebungstemperatur des äußeren Behälters (60).

6. Magnetische Resonanz-Bildaufnahmevorrichtung (1000; 2000) nach Anspruch 1, wobei das Hitzeschildelement (18) eine Röhre ist.

## Revendications

1. Système d'imagerie à résonnance magnétique (1000; 2000) comprenant:-
une unité d'imagerie à résonnance magnétique (600) ayant une chambre d'imagerie (3) à l'intérieur, pour recevoir un patient (P) en examen médical;
une unité à solénoïde superconducteur (15) contenue dans une enveloppe extérieure (60) qui entoure la chambre d'imagerie (3) et comprenant un moyen à solénoïde superconducteur (17) pour produire de manière uniforme un champ magnétique statique pour l'appliquer au patient (P) et au moins un élément de blindage thermique (18) pour servir de blindage thermique au moyen à solénoïde superconducteur (17);
un moyen à solénoïde à champ magnétique à gradient (50) placé entre l'enveloppe extérieure (60) et la chambre d'imagerie (3) pour produire un champ magnétique à gradient qui se superpose au champ magnétique statique,
caractérisé par le fait que:-
le moyen à solénoïde à gradient à blindage actif (52) pour produire un champ magnétique de blindage à gradient (H_{GS}), est placé à l'intérieur de l'enveloppe extérieure (60) de façon à établir un couplage thermique entre ce moyen à solénoïde à gradient à blindage actif (52) et l'élément de blindage thermique (18) et un couplage magnétique entre ce moyen à solénoïde à gradient à blindage actif (52) et le champ de fuite (H_{GL}) du champ mgnétique à gradient du moyen à solénoïde à champ magnétique à gradient (50), de sorte que le champ magnétique du champ de fuite (H_{GL}) soit annulé par le champ magnétique du blindage à gradient (H_{GS}) et que pratiquement aucun courant de Foucault ne puisse être produit à l'intérieur de l'élément de blindage thermique (18).

2. Système d'imagerie à résonnance magnétique (1000;2000) selon la revendication 1, dans lequel le moyen à solénoïde à gradient à blindage actif (52) est placé tout près de l'élément de blindage thermique (18) à l'intérieur de l'enveloppe extérieure (60).

3. Système d'imagerie à résonnance magnétique (1000;2000) selon la reevendication 1 ou la revendication 2 comprenant en outre:-
un second élément de blindage thermique (19) à l'intérieur de l'élément de blindage thermique (18) pour servir d'enceint thermique au moyen à solénoïde superconducteur (17).

4. Système d'imagerie à résonnance magnétique (1000) selon la revendication 3 comprenant en outre:-
une unité de réfrigération (54) pour refroidir les deux éléments de blindage thermique (18;19) à des températures prédéterminées inférieures à la température ambiante de l'enveloppe extérieure (60).

5. Système d'imagerie à résonnance magnétique (2000) selon la revendication 3 comprenant en outre:-
un troisième élément de blindage thermique (65) servant d'enceinte au second élément de blindage thermique (19) et au moyen à solénoïde à gradient à blindage actif (52) à l'intérieur de l'enveloppe extérieure (60); et
un réfrigérateur (54) pour refroidir au moins le premier élément de blindage thermique (18) et le moyen à solénoïde à gradient à blindage actif (52) à des températures prédéterminées inférieures à la température ambiante de l'enveloppe extérieure (60).

6. Système d'imagerie à résonnance magnétique (1000;2000) selon la revendication 1, dans lequel l'élément de blindage thermique (18) est un tube.
